# EUROPEAN PATENT SPECIFICATION

(11) **EP 0 718 884 B1**
(45) Date of publication and mention of the grant of the patent: **13.08.2003**
(21) Application number: 95309326.7
(22) Date of filing: 21.12.1995
(51) Int. Cl.: H01L 23/532

(54) **Multilevel interconnection of semiconductor device and forming method thereof**
Mehrlagenverbindung einer Halbleiteranordnung und Herstellungsverfahren
Interconnexion multicouche d'un dispositif semi-conducteur et procédé de sa fabrication

(30) Priority: 23.12.1994 KR 9436420
(43) Date of publication of application: 26.06.1996
(73) Proprietor: Samsung Electronics Co., Ltd., Suwon-city, Kyungki-do 441-370 (KR)
(72) Inventor: Lee, Yong-jae, Seoul (KR); Lee, Soo-cheol, Seoul (KR)
(74) Representative: Ertl, Nicholas Justin

(56) References cited:
- EP-A- 0 220 517
- EP-A- 0 326 204
- DE-A- 4 210 821
- US-A- 5 250 846

## Description

The present invention relates to a semiconductor device and a forming method thereof, and, more particularly, to a multilevel interconnection of a semiconductor device having a lower conductive layer of which the uppermost surface is formed of silicide connected through a contact hole to an impurity-containing upper conductive layer, and a forming method thereof.

A multilayer interconnecting method for forming the conductive layers of an integrated semiconductor device into a multilayer structure can increase integration while maintaining electrical reliability of the device. In such a structure, contact resistance between conductive layers is the most important factor in determining the electrical reliability. Here, even though conductive materials having a low resistance may be used to form an interconnection, the contact resistance resulting may be high, with the result that the overall resistance of the whole interconnection is increased, which leads to serious deterioration in the electrical characteristics of the device. The contact resistance depends largely on the dimensions of the contact hole. With current technology, since contact holes tend to become smaller as integration increases, change in the contact resistance with reduction of the contact hole's dimension is an increasingly important issue in semiconductor manufacturing.

Conventionally, aluminum has been used as the material constituting the interconnection. Aluminum has the advantage of a low sheet resistance, while it has a disadvantage of a low melting point. This causes a serious problem in that the interconnection is deformed by the heat energy provided when the device is manufactured. Therefore, at present, a conductive material such as polysilicon is generally used as the material constituting the interconnection. Polysilicon is adaptable to control the magnitude of the sheet resistance by concentration of doped impurities and has a high melting point, which prevents the interconnection from deforming even at high thermal energy.

Monolayer-structured polysilicon into which a N-type or P-type impurity is doped, or multilayered polycide in which silicide such as tungsten silicide (WSiₓ) is laminated on the monolayer-structured polysilicon is generally used.

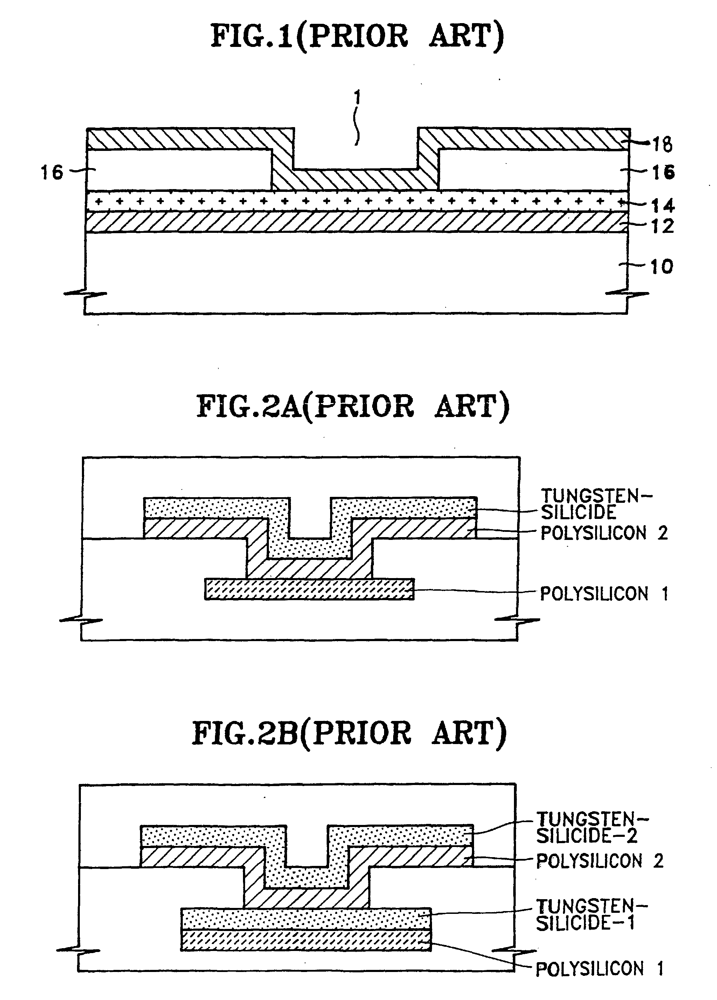

FIG. 1 is a cross-sectional view showing a general multilevel interconnection between a polycide layer and a polysilicon layer. Here, reference numeral 10 denotes a semiconductor substrate, 12 denotes a first polysilicon layer, 14 denotes a first silicide layer, 16 denotes an interlayer dielectric layer, 18 denotes a second polysilicon layer, and 1 denotes a contact hole.

Referring to FIG. 1, in the formation of the multilevel interconnection, a lower conductive layer of a polycide structure in which first polysilicon layer 12 and first silicide layer 14 are laminated onto semiconductor substrate 10 is connected to an upper conductive layer such as a mono-layered second polysilicon 18 through contact hole 1 formed in interlayer dielectric layer 16.

Pure polysilicon cannot be used as the conductive material due to its high sheet resistance. However, if ions are doped into the pure polysilicon in a predetermined manner, the sheet resistance is reduced and thus the doped polysilicon can be used as a conductive material. Generally, the doping of impurities into pure polysilicon is carried out during or after the deposition of polysilicon.

Moreover, as silicide has a much lower resistance than impurity-doped polysilicon, a conductive layer having a structure that a silicide layer is laminated on a polysilicon layer (i.e., polycide structure) is mainly used.

For a general multilevel interconnection having a polycide structure, the resistance of the interconnection could be reduced by laminating a silicide layer with a low resistance on a polysilicon layer. The impurity ions doped into the polysilicon, however, diffuse through the interface between a polysilicon layer and a silicide layer to thus increase the contact resistance. Therefore, the electrical characteristics and integration degree of the device are deteriorated.

FIG. 2A is a cross-sectional view of a multilevel interconnection having a lower conductive layer constituted a polysilicon, and FIG. 2B is a cross-sectional view of a multilevel interconnection having a polycide-structured lower conductive layer.

In FIG 2A, a lower conductive layer is made of only first polysilicon and an upper conductive layer has a polycide structure in which second polysilicon and tungsten silicide are sequentially laminated on the first polysilicon. Here, silicide is not interposed between first and second polysilicon.

In FIG. 2B, a lower conductive layer has a polycide structure in which first polysilicon and first tungsten silicide are sequentially laminated and an upper conductive layer has a polycide structure in which second polysilicon and second tungsten silicide are sequentially laminated. Here, silicide is interposed between first and second polysilicon.

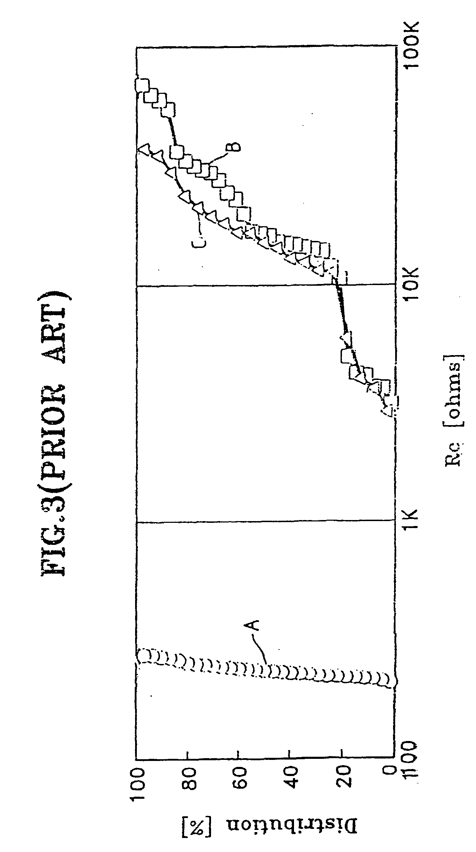

FIG. 3 is a graph showing a distribution of multilevel interconnection resistances according to the structure of the lower conductive layer, in which "A" represents a contact resistance between polysilicon layers when phosphorus ions are doped into the polysilicon, "B" represents a contact resistance between a polycide-structured lower conductive layer and an upper conductive layer where boron ions are doped into the polysilicon constituting the upper conductive layer, and "C" represents a contact resistance between a polycide-structured lower conductive layer and an upper conductive layer where arsenic ions are doped into the polysilicon constituting the upper conductive layer.

Referring to FIG. 3, it can be seen that the contact resistance generated when a polysilicon layer is directly connected to another polysilicon layer is much lower than that between a polycide layer and a polysilicon layer.

It is assumed that this is due to the increase of the contact resistance of a contact region by absorbing an impurity doped into the second polysilicon layer to the interface of the second polysilicon layer and the first silicide layer.

The present invention addresses the problem of providing a multilevel interconnection for reducing contact resistance between a lower conductive layer of which the uppermost surface is formed of silicide and an upper conductive layer of which the lowermost surface is formed of an impurity-containing conductive layer, to thereby form a multilayer interconnection with a high reliability.

The present invention comprises a multilevel interconnection in accordance with claim 1 and a method of manufacturing a multilevel interconnection in accordance with claim 4.

Preferably, the first silicide layer is formed of one selected from the silicide group consisting of tungsten silicide (WSi₂), titanium silicide (TiSi₂), tantalum silicide (TaSi₂) and molybdenum silicide (MoSi₂).

In the present invention, the problem caused by generation of a contact resistance by the diffusion of impurity ions doped in the polysilicon layer to the interface between the polysilicon layer and the silicide layer can be counteracted.

Examples of the invention will now be described in detail with reference to the accompanying drawings, in which:
FIG. 1 is a cross-sectional view showing a general multilevel interconnection between a polycide layer and a polysilicon layer;
FIG. 2A is a cross-sectional view of a multilevel interconnection having a lower conductive layer constituted of polysilicon;
FIG. 2B is a cross-sectional view of a multilevel interconnection having a polycide-structured lower conductive layer;
FIG. 3 is a graph showing the distribution of multilevel interconnection resistances according to the structure of the lower conductive layer;
FIG. 4 is a cross-sectional view showing a multilevel interconnection;
FIGS. 5A-5D are cross-sectional views for illustrating sequentially the forming method of the multilevel interconnection shown in Figure 4;
FIG. 6 is a cross-sectional view of a multilevel interconnection according to the present invention;
FIGS. 7A-7D are cross-sectional views for illustrating sequentially the forming method of a multilevel interconnection structure according to the present invention; and,
FIG. 8 is a graph showing contact resistance values depending on the thickness of a silicide layer of a lower conductive layer.

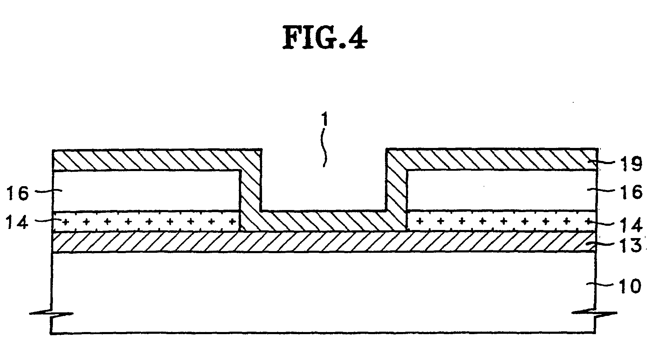

FIG. 4 is a cross-sectional view of one possible multilevel interconnection. The multilevel interconnection shown in FIG. 4 is to connect a lower conductive layer of a polycide structure in which first impurity-containing conductive layer 13 and first silicide layer 14 are sequentially laminated to an upper conductive layer constituted only of second impurity-containing conductive layer 19, through a contact hole.

First impurity-containing conductive layer 13 constituting the lower conductive layer and second impurity-containing conductive layer 19 constituting the upper conductive layer are directly connected through contact hole 1. That is, first silicide layer 14 is not interposed between first and second impurity-containing layers 13 and 19.

First and second impurity-containing conductive layers 13 and 19 are formed of impurity-doped polysilicon. Also, a second silicide layer (not shown) is further formed on second impurity-containing conductive layer 19.

First silicide layer 14 is formed on first impurity-containing conductive layer 13 except on the region where the contact hole 1 is to be formed. Second impurity-containing conductive layer 19 is connected to first impurity-containing conductive layer 13 where it is exposed by the contact hole.

As the upper and lower conductive layers are tied together without interposing silicide, by directly connecting the impurity-containing conductive layers to each other, the impurity doped into the impurity-containing conductive layer does not diffuse in the silicide layer. Therefore, the increase in contact resistance due to the diffusion of impurities does not occur.

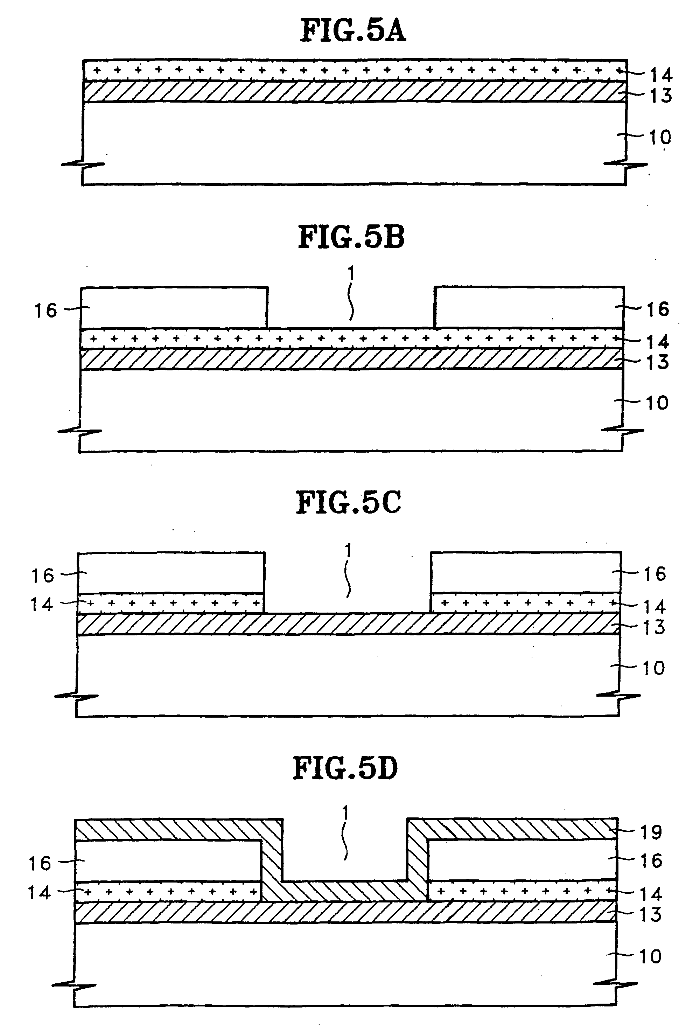

Referring to FIGS. 5A-5D, the forming process of a multilevel interconnection having this structure is explained in sequence.

FIG. 5A shows a process of forming a lower conductive layer consisting of first impurity-containing conductive layer 13 and first silicide 14. This process is performed by, in sequence, the steps of: forming first impurity-containing conductive layer 13 on semiconductor substrate 10; forming first silicide layer 14 on first impurity-containing conductive layer 13; and partially etching first silicide layer 14 and first impurity-containing conductive layer 13 to form a lower conductive layer 13 and 14.

First impurity-containing conductive layer 13 is formed by doping N-type impurity ions such as phosphorus (P) into polysilicon. First silicide layer 14 is formed by using the silicide, for example, tungsten silicide (WSi₂).

Instead of phosphorus (P), N-type impurity ions such as arsenic (As) or P-type impurity ions such as boron (B) can be doped into the polysilicon. Furthermore, first silicide layer 14 can be formed by using one selected from the silicide group consisting of titanium silicide (TiSi₂), tantalum silicide (TaSi₂), and molybdenum silicide (MoSi₂), instead of tungsten silicide (WSi₂).

FIG. 5B shows a process of forming contact hole 1. This process is performed by, in sequence, the steps of: forming interlayer dielectric layer 16 on the resultant substrate where a lower conductive layer is formed; and partially etching the interlayer dielectric layer of the region where a contact hole is to be formed to form contact hole 1 for partially exposing first silicide layer 14. Here, interlayer dielectric layer 16 is formed by using insulation material such as silicon dioxide (SiO₂).

FIG. 5C shows a process of etching first silicide layer 14. This process is performed by the step of removing the exposed first silicide layer to partially expose first impurity-containing conductive layer 13. FIG. 5D shows a process of forming second impurity-containing conductive layer 19. This process is performed by the step of forming second impurity-containing conductive layer 19 on the resultant substrate where first impurity-containing conductive layer 13 is partially exposed. Here, second impurity-containing conductive layer 19 is formed by doping impurities into polysilicon. The impurities doped into second impurity-containing conductive layer 19 have the same conductive type (i.e. N-type or P-type) as those doped into first impurity-containing conductive layer 13.

Second impurity-containing conductive layer 19 is connected to first impurity-containing conductive layer 13 where exposed through contact hole 1.

Moreover, after the step of forming second impurity-containing conductive layer 19, a second silicide layer (not shown) is further formed on the second impurity-containing conductive layer by depositing silicide, for example, tungsten silicide (WSi₂). Again, the second silicide layer can be formed by depositing one selected from the silicide group consisting of titanium silicide (TiSi₂), tantalum silicide (TaSi₂) and molybdenum silicide (MoSi₂), instead of tungsten silicide (WSi₂).

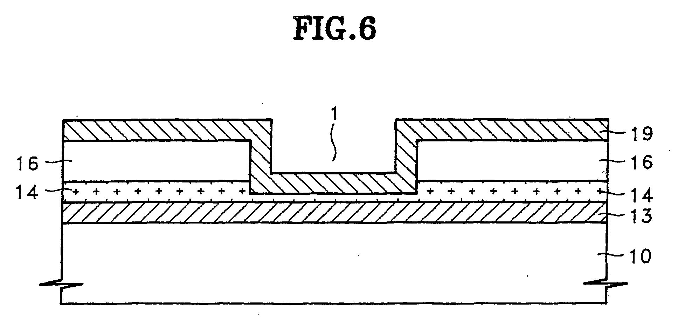

Referring to FIG. 6, a multilevel interconnection according to the invention connects first impurity-containing conductive layer 13 constituting a lower conductive layer to second impurity-containing conductive layer 19 constituting an upper conductive layer by interposing first silicide layer 14.

Here, the first silicide layer formed on the region where a contact hole is to be formed is thinner than the first silicide layer formed on a region other than that on which a contact hole is to be formed. Preferably, the thickness of the first silicide layer formed on the region where a contact hole is to be formed is two thirds the thickness of the first silicide layer formed on the other region.

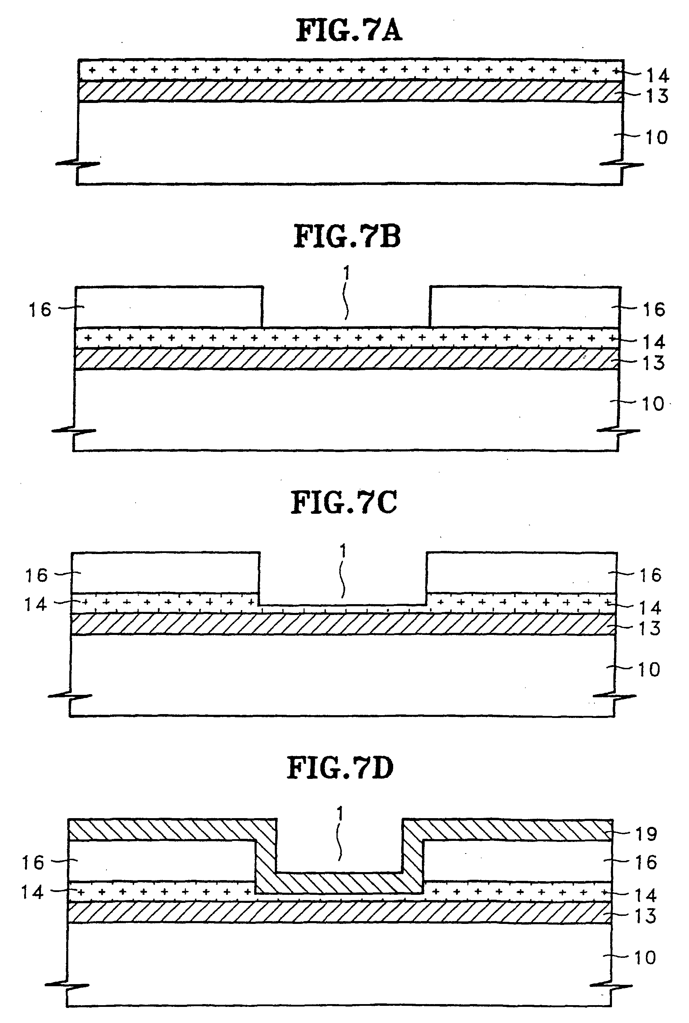

Referring to FIGS. 7A-7D, the forming process of a multilevel interconnection according to the invention is explained sequentially.

First impurity-containing conductive layer 13 is formed on semiconductor substrate 10 by depositing the impurity-doped polysilicon, and first silicide layer 14 is then laminated thereon, for example, to a thickness of 500-3,000Å (FIG. 7A), where 10Å=1nm.

After interlayer dielectric layer 16 is formed on silicide layer 14 and then partially etched (FIG. 7B), the first silicide layer exposed through contact hole 1 is partially etched such that the thickness of the layer is reduced to two thirds or less of the original thickness of the layer (i.e., about 200Å in a preferred case), and thus the first silicide layer formed on the region where a contact hole is to be formed is formed to be thinner than the first silicide layer formed on a region other than that on which a contact hole is to be formed (FIG. 7C).

After this, second impurity-containing conductive layer 19 is formed according to the same process as explained above for the first embodiment (FIG. 7D).

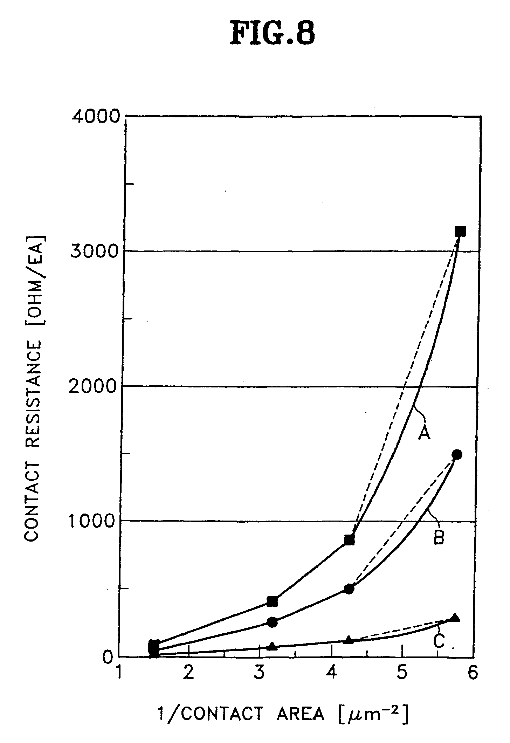

Referring to FIG. 8, contact resistant values depending on the thickness of a silicide layer of a lower conductive layer are plotted on the graph.

A lower conductive layer is formed with polysilicon of 900Å thickness is laminated on polysilicon of 900Å thickness, and an upper conductive layer is formed with polysilicon of 900Å thickness.

In FIG. 8, "A" represents contact resistance to 1/contact area when the silicide layer is not etched at all, "B" represents contact resistance to 1/contact are when the silicide layer is etched by about 700Å, and "C" represents contact resistance to 1/contact area when the silicide layer is etched by about 1,000Å.

According to the graph of FIG. 8, the thinner the silicide layer formed on the region where a contact hole is to be formed is, the lower is the contact resistance between the upper conductive layer and lower conductive layer.

According to the multilevel interconnection and a forming method thereof of the present invention, for a contact structure connecting a lower conductive layer of which the uppermost surface is made of a silicide layer to an upper conductive layer of which lowermost surface is made of an impurity-containing conductive layer, the silicide layer constituted in the lower conductive layer is formed to be as thin as possible, thereby to prevent increase of contact resistance by the diffusion of the impurity ions doped into a polysilicon layer to the interface between a polysilicon layer and a silicide layer.

The present invention is not limited to the above example and many variations thereof can be available to those skilled in this art.

## Claims

1. A multilevel interconnection comprising:
a first doped polysilicon layer (13) formed on a semiconductor substrate (10);
a first silicide layer (14) having a first region and a second region and being formed on said first doped polysilicon layer (13), wherein the thickness of said first region is about 20nm and equal to or less than two thirds of the thickness of said second region;
an interlayer dielectric layer (16) formed on said second region of said first silicide layer (14) and comprising a contact hole (1) exposing said first region of said first silicide layer (14);
a second doped polysilicon layer (19) connected to said first silicide layer (14) through said contact hole (1); and
a second silicide layer formed on said second doped polysilicon layer.

2. A multilevel interconnection as claimed in claim 1, wherein the thickness of said second region is 50-300 nm.

3. A multilevel interconnection as claimed in any preceding claim, wherein said first silicide layer (14) is formed of one selected from the silicide group consisting of tungsten silicide, titanium silicide , tantalum silicide and molybdenum silicide.

4. A method of forming a multilevel interconnection,
comprising the steps of:
forming a first doped polysilicon layer on a semiconductor substrate;
forming a first silicide layer on said first doped polysilicon layer;
forming an interlayer dielectric layer on said first silicide layer;
forming a contact hole in said interlayer dielectric layer by etching the interlayer dielectric layer;
etching a first region of said first silicide layer exposed through the contact hole to form a first etched region and a second nonetched region in said first silicide layer, said first region having a thickness which is about 20nm and equal to or less than two thirds of said second region thickness;
forming a second doped polysilicon layer on the resultant substrate so that said second doped polysilicon layer is connected to said first silicide layer; and
forming a second silicide layer on said second doped polysilicon layer.

5. A method of forming a multilevel interconnection as claimed in claim 4, wherein said first silicide layer is formed of one selected from the silicide group consisting of tungsten silicide, titanium silicide, tantalum silicide and molybdenum silicide.

## Patentansprüche

1. Mehrlagenverbindung umfassend:
eine erste dotierte Polysiliciumschicht (13), die auf einem Halbleitersubstrat (10) ausgebildet ist;
eine erste Silicidschicht (14) mit einer ersten Region und einer zweiten Region und ausgebildet auf der ersten dotierten Polysiliciumschicht (13), worin die Dicke der ersten Region ungefähr 20 nm beträgt und gleich oder kleiner ist als zwei Drittel der Dicke der zweiten Region;
eine dielektrische Zwischenschicht (16), die auf der zweiten Region der ersten Silicidschicht (14) ausgebildet ist und einen Kontaktdurchtritt (1) umfasst, der die erste Region der ersten Silicidschicht (14) freilegt;
eine zweite dotierte Polysiliciumschicht (19), die mit der ersten Silicidschicht (14) durch den Kontaktdurchtritt (1) verbunden ist; und
eine zweite Silicidschicht, die auf der zweiten dotierten Polysiliciumschicht ausgebildet ist.

2. Mehrlagenverbindung nach Anspruch 1, worin die Dicke der zweiten Region 50 bis 300 nm beträgt.

3. Mehrlagenverbindung nach einem der vorhergehenden Ansprüche, worin die erste Silicidschicht (14) auf einem ausgewählt aus der Silicidgruppe bestehend aus Wolframsilicid, Titansilicid, Tantalsilicid und Molybdänsilicid ausgebildet ist.

4. Verfahren zur Herstellung einer Mehrlagenverbindung umfassend die Schritte:
Ausbilden einer ersten dotierten Polysiliciumschicht auf einem Halbleitersubstrat;
Ausbilden einer ersten Silicidschicht auf der ersten dotierten Polysiliciumschicht;
Ausbilden einer dielektrischen Zwischenschicht auf der ersten Silicidschicht;
Ausbilden eines Kontaktdurchtritts in der dielektrischen Zwischenschicht durch Ätzen der dielektrischen Zwischenschicht;
Ätzen einer ersten Region der ersten Silicidschicht, die durch den Kontaktdurchtritt freigelegt ist, um eine erste geätzte Region und eine zweite nicht geätzte Region in der ersten Silicidschicht auszubilden, wobei die erste Region eine Dicke aufweist, die ungefähr 20 nm beträgt und gleich oder kleiner ist als zwei Drittel der Dicke der zweiten Region;
Ausbilden einer zweiten dotierten Polysiliciumschicht auf dem erhaltenen Substrat, so dass die zweite dotierte Polysiliciumschicht mit der ersten Silicidschicht verbunden wird; und
Ausbilden einer zweiten Silicidschicht auf der zweiten dotierten Polysiliciumschicht.

5. Verfahren zur Herstellung einer Mehrlagenverbindung nach Anspruch 4, worin die erste Silicidschicht ausgebildet wird auf einer ausgewählt aus der Silicidgruppe bestehend aus Wolframsilicid, Titansilicid, Tantalsilicid und Molybdänsilicid.

## Revendications

1. Interconnexion multicouche comprenant :
une première couche de polysilicium dopé (13) formée sur un substrat semiconducteur (10) ;
une première couche de siliciure (14) comportant une première région et une seconde région et étant formée sur ladite première couche de polysilicium dopé (13), dans laquelle l'épaisseur de ladite première région est d'environ 20 nm et est égale ou inférieur aux deux tiers de l'épaisseur de ladite seconde région ;
une couche diélectrique intermédiaire (16) formée sur ladite seconde région de ladite première couche de siliciure (14) et comprenant un trou de contact (1) faisant apparaître ladite première région de ladite première couche de siliciure (14) ;
une seconde couche de polysilicium dopé (19) reliée à ladite première couche de siliciure (14) par l'intermédiaire dudit trou de contact (1) ; et
une seconde couche de siliciure, formée sur ladite seconde couche de polysilicium dopé.

2. Interconnexion multicouche selon la revendication 1, dans laquelle l'épaisseur de ladite seconde région est de 50 à 300 nm.

3. Interconnexion multicouche selon l'une quelconque des revendications précédentes, dans laquelle ladite première couche de siliciure (14) est formée sur un élément choisi dans le groupe de siliciures constitué du siliciure de tungstène, siliciure de titane, siliciure de tantale et siliciure de molybdène.

4. Procédé de formation d'une interconnexion multicouche,
comprenant les étapes consistant à :
former une première couche de polysilicium dopé sur un substrat semiconducteur ;
former une première couche de siliciure sur ladite première couche de polysilicium dopé ;
former une couche diélectrique intermédiaire sur ladite première couche de siliciure ;
former un trou de contact dans ladite couche diélectrique intermédiaire par gravure de la couche diélectrique intermédiaire ;
graver une première région de ladite première couche de siliciure et apparaissant à travers le trou de contact pour former une première région gravée et une seconde région non gravée dans ladite première couche de siliciure, ladite première région ayant une épaisseur d'environ 20 nm et égale ou inférieure aux deux tiers de l'épaisseur de ladite seconde région ;
former une seconde couche de polysilicium dopé sur le substrat résultant, de telle sorte que ladite seconde couche de polysilicium dopé soit reliée à ladite première couche de siliciure ; et
former une seconde couche de siliciure sur ladite seconde couche de polysilicium dopé.

5. Procédé de formation d'une interconnexion multicouche selon la revendication 4, dans lequel ladite première couche de siliciure est formée sur un élément choisi dans le groupe de siliciures constitué du siliciure de tungstène, siliciure de titane, siliciure de tantale et siliciure de molybdène.
